# EUROPEAN PATENT APPLICATION

(11) **EP 2 571 044 A1**
(43) Date of publication of application: **20.03.2013**
(21) Application number: 11780524.2
(22) Date of filing: 27.04.2011
(51) Int. Cl.: H01L 21/368, H01L 21/336, H01L 29/786, H01L 51/05

(54) **ORGANIC SEMICONDUCTOR FILM AND METHOD FOR MANUFACTURING THE SAME, AND STAMP FOR CONTACT PRINTING**

(30) Priority: 27.08.2010 JP 2010191159; 27.08.2010 JP 2010191054; 12.05.2010 JP 2010110263; 12.05.2010 JP 2010110230; 12.05.2010 JP 2010110219
(71) Applicant: Teijin Limited, Osaka-shi, Osaka 541-0054 (JP)
(72) Inventor: KUSHIDA, Takashi, Hino-shi Tokyo 191-0065 (JP); NAITO, Hiroyoshi, Sakai-shi Osaka 599-8531 (JP)
(74) Representative: Hallybone, Huw George
(86) International application number: PCT/JP2011/060296
(87) International publication number: WO 2011/142267

(57) **Abstract**

Disclosed is an organic semiconductor film (10) which has a value of 1 or more but less than 10 for the ratio of the charge mobility [(charge mobility of the surface side having larger charge mobility)/(charge mobility of the surface side having smaller charge mobility)] of two opposing surface sides (11, 12). In addition, the organic semiconductor film (10) has a relative X-ray reflectance peak height of 2.0 or more with respect to the peak height of an organic semiconductor film which has the same thickness and materials and is manufactured by performing spin coating on a silicon wafer. Alternatively, the organic semiconductor film (10) has a value of 2 or more for the ratio of the charge mobility [(charge mobility of the surface side having larger charge mobility)/(charge mobility of the surface side having smaller charge mobility)] of the two opposing surface sides (11, 12).

## Description

### TECHNICAL FIELD

First and second aspects of the present invention relate to a novel organic semiconductor film, a production method thereof, and an organic semiconductor device and an electric circuit each having an organic semiconductor film.

A third aspect of the present invention relates to a novel contact printing stamp, particularly a contact printing stamp used for the production of an organic semiconductor film, and a production method of an organic semiconductor film using the contact printing stamp.

### BACKGROUND ART

In recent years, a semiconductor film is used in various semiconductor devices such as a thin-film transistor (TFT), and solar cell.

An inorganic semiconductor film predominantly used at present, particularly an inorganic semiconductor film using silicon as a semiconductor material, requires a vacuum process such as chemical vapor deposition (CVD) and sputtering, and therefore the production cost thereof is high. Also, in view of process temperature, it is difficult to form an inorganic semiconductor film on a polymer film or the like. Furthermore, the inorganic semiconductor film does not satisfy the requirement for reduction in cost of a lightweight flexible device, RF-ID (Radio Frequency IDentification) and the like which are expected to be put into practice in the future.

In order to solve these problems, use of an organic semiconductor film formed of an organic semiconductor material is proposed. A vacuum deposition apparatus or a coating apparatus used in the production of an organic semiconductor film is inexpensive as compared with a CVD apparatus or a sputtering apparatus used in the production of an inorganic semiconductor film. In addition, in the production of an organic semiconductor film, the process temperature is low, and therefore it is also possible to form an organic semiconductor film on a polymer film, paper or the like.

Regarding the formation of an organic semiconductor film, it is known to use a solution method (for example, a casting method, a spin coating method, a printing method such as contact printing, and a dipping method) of coating a solution containing an organic semiconductor material on a substrate, a stamp or the like, and then removing the solvent; and a vapor deposition method of depositing an organic semiconductor material on a substrate. Among these methods, the solution method is generally known to be preferred in terms of production cost, production speed and the like, and on this account, various studies are being made thereon (Patent Documents 1 to 3 and Non-Patent Documents 1 and 2). However, it has not been always possible to stably obtain a high-quality organic semiconductor film by the solution method.

Incidentally, with an attempt to provide a field-effect organic transistor having high mobility and high on-off ratio, a field-effect transistor in which the organic semiconductor layer has at least two or more areas differing in the mobility has been proposed (Patent Document 4). The technique described in Patent Document 4 decreases the leak current by forming areas differing in the mobility in an organic semiconductor layer and thereby enhances the on-off ratio, but it is speculated that the mobility is not enhanced as compared with a conventional organic semiconductor layer.

### RELATED ART

### PATENT DOCUMENT

Patent Document 1: JP-A-2007-311377
Patent Document 2: JP-A-2009-212127
Patent Document 3: JP-A-2008-277728
Patent Document 4: JP-A-2005-32978

### NON-PATENT DOCUMENT

Non-Patent Document 1: Atsushi TAKAKUWA and Reiko AZUMI, "Influence of Solvents in Micropatterning of Semiconductors by Microcontact Printing and Application to Thin-Film Transistor Devices", Jpn. J. Appl. Phys., Vol. 47, No. 2, 2008, pp. 1115-1118
Non-Patent Document 2: Y.H. Kim etc., "Fabrication of Poly(3-hexylthiophene) Thin Film Transistors Using Microcontact Printing Technology", Proc. Int. Disp. Workshops, Vol. 9, pp. 255-258 (2002)

### SUMMARY OF THE INVENTION

### PROBLEMS TO BE SOLVED BY THE INVENTION

An object of the first and second aspects of the present invention is to provide a novel organic semiconductor film, a production method thereof, and an organic semiconductor device having the organic semiconductor film.

An object of the third aspect of the present invention is to provide a novel contact printing stamp, particularly a contact printing stamp used for the production of an organic semiconductor film, and a production method of an organic semiconductor film using the contact printing stamp.

### MEANS TO SOLVE THE PROBLEMS

### «First Aspect of the Present Invention»

The present inventors have found, regarding the production of an organic semiconductor film by a solution method, that when an undried organic semiconductor film is matured on a substrate or a first stamp, the charge mobility of the organic semiconductor film is improved on the surface not contacting the substrate or first stamp; and that when the surface energy of such a substrate or first stamp is small, the charge mobility of the organic semiconductor film is also improved on the surface contacting the substrate or first stamp. The following first aspect of the present invention, i.e., a novel organic semiconductor film, a production method thereof and an organic semiconductor device, has been accomplished based on this finding.

<1> An organic semiconductor film, wherein the value of the ratio of charge mobilities on two opposing surfaces {(charge mobility on the surface with high charge mobility)/(charge mobility on the surface with low charge mobility)} is from 1 to less than 10; and the relative X-ray reflection peak height is 2.0 or more on the basis of the peak height for an organic semiconductor film having the same thickness, made of the same material and produced by spin coating on a silicon wafer.

<2> The organic semiconductor film as described in <1> above, wherein the value of the ratio of charge mobilities is 5 or less.

<3> The organic semiconductor film as described in <1> or <2> above, wherein the organic semiconductor film is obtained by a solution method.

<4> The organic semiconductor film as described in any one of <1> to <3> above, wherein the organic semiconductor film is obtained by a contact printing method.

<5> The organic semiconductor film as described in any one of <1> to <4> above, wherein the charge mobility on the surface with high charge mobility of the organic semiconductor film is 1.00×10⁻⁵ cm²/(V·s) or more.

<6> A method for producing an organic semiconductor film, comprising:
providing an organic semiconductor solution comprising an organic semiconductor material dissolved and/or dispersed therein,
applying the organic semiconductor solution on a substrate or a first stamp to obtain an undried organic semiconductor film, and
maturing the undried organic semiconductor film on the substrate or first stamp,
wherein the water contact angle on the surface of the substrate or first stamp is 100° or more.

<7> The method as described in <6> above, wherein the maturing is performed by holding the undried organic semiconductor film over 10 seconds or more.

<8> The method as described in <6> or <7> above, wherein the maturing is performed by holding the undried organic semiconductor film in an atmosphere having a temperature of less than 50°C.

<9> The method as described in any one of <6> to <8> above, further comprising transferring the organic semiconductor layer matured on the first stamp.

<10> The method as described in any one of <6> to <9> above, further comprising drying and/or thermal annealing the organic semiconductor layer matured on the substrate or first stamp.

<11> The method as described in any one of <6> to <10> above, wherein the water contact angle on the surface of the substrate or first stamp is 105° or more.

<12> An organic semiconductor device having the organic semiconductor film described in any one of <1> to <5> above.

<13> The organic semiconductor device as described in <12> above, which is a thin-film transistor.

<14> The organic semiconductor device as described in <13> above, wherein the organic semiconductor film is obtained by a contact printing method, and the organic semiconductor device is a bottom-gate bottom-contact or top-gate bottom-contact thin-film transistor.

### «Second Aspect of the Present Invention»

The present inventors have found, regarding the production of an organic semiconductor film by a solution method, that when an undried organic semiconductor film is matured on a substrate or a first stamp, the charge mobility of the organic semiconductor film is improved on the surface not contacting the substrate or first stamp. The following second aspect of the present invention, i.e., a novel organic semiconductor film, a production method thereof and an organic semiconductor device, has been accomplished based on this finding.

<15> An organic semiconductor film, wherein the value of the ratio of charge mobilities on two opposing surfaces {(charge mobility on the surface with high charge mobility)/(charge mobility on the surface with low charge mobility)} is 2 or more.

<16> The organic semiconductor film as described in <15> above, wherein the value of the ratio of charge mobilities is 10 or more.

<17> The organic semiconductor film as described in <15> or <16> above, wherein the value of the ratio of charge mobilities is 150 or less.

<18> The organic semiconductor film as described in any one of <15> to <17> above, wherein the organic semiconductor film is obtained by a solution method.

<19> The organic semiconductor film as described in any one of <15> to <18> above, wherein the organic semiconductor film is obtained by a contact printing method.

<20> The organic semiconductor film as described in any one of <15> to <19> above, wherein the charge mobility on the surface with high charge mobility of the organic semiconductor film is 1.00×10⁻⁵ cm²/(V·s) or more.

<21> The organic semiconductor film as described in any one of <15> to <20> above, wherein the relative X-ray reflection peak height is 1.3 or more on the basis of the peak height for an organic semiconductor film having the same thickness, made of the same material and produced by spin coating on a silicon wafer.

<22> The organic semiconductor film as described in any one of <15> to <21> above, wherein the degree of crystal orientation of an organic semiconductor material constituting the organic semiconductor film is gradually changed between the two opposing surfaces.

<23> A method for producing an organic semiconductor film, comprising:
providing an organic semiconductor solution comprising an organic semiconductor material dissolved and/or dispersed therein,
applying the organic semiconductor solution on a substrate or a first stamp to obtain an undried organic semiconductor film, and
maturing the undried organic semiconductor film on the substrate or first stamp.

<24> The method as described in <23> above, wherein the maturing is performed by holding the undried organic semiconductor film over 10 seconds or more.

<25> The method as described in <23> or <24> above, wherein the maturing is performed by holding the undried organic semiconductor film in an atmosphere having a temperature of less than 50°C.

<26> The method as described in any one of <23> to <25> above, further comprising transferring the organic semiconductor layer matured on the first stamp.

<27> The method as described in any one of <23> to <26> above, further comprising drying and/or thermal annealing the organic semiconductor layer matured on the substrate or first stamp.

<28> The method as described in any one of <23> to <27> above, wherein the water contact angle on the surface of the substrate or first stamp is 40° or more.

<29> An organic semiconductor device having the organic semiconductor film described in any one of <15> to <22> above.

<30> The organic semiconductor device as described in <29> above, which is a thin-film transistor.

<31> The organic semiconductor device as described in <30> above, wherein the organic semiconductor film is obtained by a contact printing method, and the organic semiconductor device is a bottom-gate bottom-contact or top-gate bottom-contact thin-film transistor.

<32> An electric circuit comprising a circuit substrate having on one surface thereof two or more thin-film transistors described in <30> or <31>,
wherein, in at least one of the thin-film transistors, the organic semiconductor film is disposed by arranging the surface with high charge mobility of the organic semiconductor film to face the circuit substrate, and this surface serves as the active surface of the thin-film transistor, and
wherein, in at least another one of the thin-film transistors, the organic semiconductor film is disposed by arranging the surface with high charge mobility of the organic semiconductor film to face opposite the circuit substrate, and this surface serves as the active surface of the thin-film transistor.

The present inventors have found that, by using a contact printing stamp having a transfer part with low surface energy and a peripheral part with high surface energy surrounding the transfer part, the charge mobility of the obtained organic semiconductor film is improved. The following third aspect of the present invention, i.e., a novel contact printing stamp and a production method of an organic semiconductor film using the contact printing stamp, has been accomplished based on this finding.

<33> A contact printing stamp having a transfer part for holding an organic semiconductor film to be transferred, and a peripheral part surrounding the transfer part, wherein the water contact angle of the transfer part is larger by 20° or more than the water contact angle of the peripheral part.

<34> The stamp as described in <33> above, wherein the water contact angle of the transfer part is 40° or more.

<35> The stamp as described in <33> or <34> above, wherein the transfer part and the peripheral part are on the same plane.

<36> The stamp as described in any one of <33> to <35> above, wherein the transfer part is concaved with respect to the peripheral part.

<37> The stamp as described in any one of <33> to <36> above, wherein the size of the transfer part is from 0.01 to 1,000,000 µm².

<38> A method for producing an organic semiconductor film, comprising:
providing an organic semiconductor solution containing a solvent and an organic semiconductor material dissolved and/or dispersed in the solvent, and
applying the organic semiconductor solution on the transfer part of the stamp described in any one of <33> to <37> above to obtain an organic semiconductor film.

### EFFECTS OF THE INVENTION

According to the novel organic semiconductor film of the first aspect of the present invention, high charge mobility can be provided to both the surface not contacting the substrate or first stamp, and the surface contacting the substrate or first stamp.

According to the novel organic semiconductor film of the second aspect of the present invention, by using a surface with high charge mobility as the active surface, high charge mobility can be provided.

According to the novel contact printing stamp of the third aspect of the present invention, an organic semiconductor film having improved semiconductor characteristics, for example, the organic semiconductor films of the first and second aspects of the present invention, can be produced.

### BRIEF DESCRIPTION OF THE DRAWINGS

[Fig. 1] Fig. 1 is a view for explaining the organic semiconductor films of the first and second aspects of the present invention.
[Fig. 2] Fig. 2 is a view for explaining the method for producing the organic semiconductor films of the first and second aspects of the present invention.
[Fig. 3] Fig. 3 is a view for explaining the method for producing a conventional organic semiconductor film.
[Fig. 4] Fig. 4 is a view for explaining the thin-transistors of the first and second aspects of the present invention.
[Fig. 5] Fig. 5 is a view for explaining the stamp having a transfer part-peripheral part structure of the third aspect of the present invention.
[Fig. 6] Fig. 6 is a side cross-sectional view of the stamp having a transfer part-peripheral part structure of the third aspect of the present invention.

### MODE FOR CARRYING OUT THE INVENTION

### «Organic Semiconductor Film of First Aspect of the Present Invention»

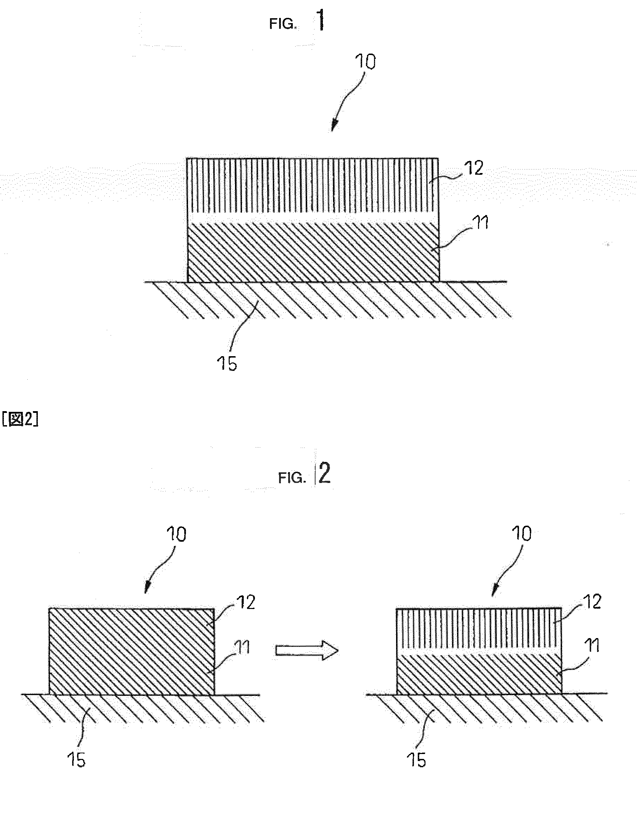

In the organic semiconductor film of the first aspect of the present invention, the value of the ratio of charge mobilities on two opposing surfaces {(charge mobility on the surface with high charge mobility)/(charge mobility on the surface with low charge mobility)} is from 1 to less than 10; and the relative X-ray reflection peak height is 2.0 or more on the basis of the peak height for an organic semiconductor film having the same thickness, made of the same material and produced by spin coating on a silicon wafer. The value of the ratio of charge mobilities may be, for example, 7 or less, 5 or less, or 3 or less. That is, as shown in Fig. 1, in the semiconductor film 10 of the first aspect of the present invention, the difference between the charge mobility on the surface 11 contacting a substrate 15 and the charge mobility on the opposite surface 12 is relatively small. Incidentally, the charge mobility can be evaluated not only by direct measurement but also by orientation, degree of crystallization, or the like of the surface of the organic semiconductor film.

According to the organic semiconductor film of the first aspect of the present invention, whichever surface is used as the active surface, high charge mobility can be provided.

In the organic semiconductor film of the first aspect of the present invention, the relative X-ray reflection peak height is 2.0 or more, 2.2 or more, 2.4 or more, or 2.5 or more, on the basis of the peak height for an organic semiconductor film having the same thickness, made of the same material and produced by spin coating on a silicon wafer. When the value of the relative X-ray reflection peak height is large, this means that the degree of crystallization over the entire thickness of the organic semiconductor film is large.

In the organic semiconductor film of the first aspect of the present invention, the charge mobility on both surfaces may be 1.00×10⁻⁵ cm²/(V·s) or more, 1.00×10⁻⁴ cm²/(V·s) or more, or 1.00×10⁻³ cm²/(V·s) or more. The charge mobility {cm²/(V·s)} as used in the present invention is a charge mobility on the surface of the semiconductor film and indicates how easy the charge as a hole or an electron can move.

The organic semiconductor film of the first aspect of the present invention can have an arbitrary thickness and may have, for example, a thickness of 1 nm to 1 µm, or from 10 to 500 nm.

In the organic semiconductor film of the first aspect of the present invention, the semiconductor film may be composed of an arbitrary organic semiconductor material. Examples of the organic semiconductor material include a low-molecular organic semiconductor molecule such as pentacene-based, thiophene-based, perylene-based and fullerene-based materials, and a high-molecular organic semiconductor molecule such as polyalkylthiophene, polyphenylenevinylene and polyfluorene-thiophene copolymer.

The organic semiconductor film of the first aspect of the present invention is not limited in its production method and accordingly, may be obtained, for example, by a molecular beam deposition method (MBE method), a vacuum deposition method, a chemical deposition method or a solution method.

However, in view of productivity and the like, the organic semiconductor film of the first aspect of the present invention is preferably produced by a solution method, i.e., for example, a casting method, a spin coating method, a printing method such as contact printing method, or a dipping method. In the case where the organic semiconductor film of the present invention is obtained by a solution method, the film can be distinguished from a film obtained by other methods, for example, by the presence of a slight amount of solvent remaining in the organic semiconductor film or the shape and physical properties of the film. The organic semiconductor film of the present invention can be obtained, for example, by using the method of the present invention.

### «Organic Semiconductor Film of Second Aspect of the Present Invention»

In the organic semiconductor film of the second aspect of the present invention, the value of the ratio of charge mobilities on two opposing surfaces {(charge mobility on the surface with high charge mobility)/(charge mobility on the surface with low charge mobility)} is 2 or more, 10 or more, 20 or more, 50 or more, 80 or more, or 100 or more. Also, the value of this ratio may be, for example, 150 or less, 130 or less, 100 or less, or 80 or less. That is, as shown in Fig. 1, in the semiconductor film 10 of the present invention, the difference between the charge mobility on the surface 11 contacting a substrate 15 and the charge mobility on the opposite surface 12 is relatively large. Incidentally, the charge mobility can be evaluated not only by direct measurement but also by orientation, degree of crystallization, or the like of the surface of the organic semiconductor film.

According to the organic semiconductor film of the second aspect of the present invention, the surface with high charge mobility is used as the active surface, whereby high charge mobility can be provided.

In the organic semiconductor film of the second aspect of the present invention, the relative X-ray reflection peak height may be 1.3 or more, 1.5 or more, 1.6 or more, 1.7 or more, 1.8 or more, or 1.9 or more, on the basis of the peak height for an organic semiconductor film having the same thickness, made of the same material and produced by spin coating on a silicon wafer. When the value of the relative X-ray reflection peak height is large, this means that the degree of crystallization over the entire thickness of the organic semiconductor film is large.

In regard to the charge mobility on the surface with high charge mobility of the organic semiconductor film of the second aspect of the present invention, descriptions on the organic semiconductor film of the first aspect of the present invention can be referred to. Also, in regard to the thickness, organic semiconductor material and production method of the semiconductor film of the second aspect of the present invention, descriptions on the organic semiconductor film of the first aspect of the present invention can be referred to.

Incidentally, the organic semiconductor film of the second aspect of the present invention may be free of a discontinuous plane in the thickness direction of the film, despite an organic semiconductor film having a large ratio of charge mobilities on two opposing surfaces, namely, an organic semiconductor film differing in the electrical characteristics between two opposing surfaces. More specifically, in the organic semiconductor film of the second aspect of the present invention, the degree of crystal orientation of the organic semiconductor material constituting the organic semiconductor film may be gradually changed between two opposing surfaces. According to this configuration, the problem due to discontinuous change in the degree of crystal orientation of the organic semiconductor material between two opposing surfaces can be avoided. Such an organic semiconductor film can be obtained, for example, by forming the film at a time by the method of the second aspect of the present invention. In this connection, when as in Patent Document 4, the charge mobility is made to differ between two opposing surfaces by changing the production conditions of two opposing surfaces, characteristics of the semiconductor film are considered to become discontinuous between before and after the change of production conditions.

### «Method of First Aspect of the Present Invention for Producing Organic Semiconductor Film»

The method of the first aspect of the present invention for producing an organic semiconductor film comprises providing an organic semiconductor solution comprising an organic semiconductor material dissolved and/or dispersed therein, applying the organic semiconductor solution on a substrate or a first stamp to obtain an undried organic semiconductor film, and maturing the undried organic semiconductor film on the substrate or first stamp. The water contact angle on the surface of the substrate or first stamp on which the organic semiconductor solution is applied is 100° or more, or 105° or more.

According to the method of the first aspect of the present invention for producing an organic semiconductor film, the organic semiconductor film of the first aspect of the present invention, i.e., an organic semiconductor film having high charge mobility on both of two opposing surfaces, can be produced.

Specifically, according to the method of the first aspect of the present invention for producing an organic semiconductor film, as shown in Fig. 2, an undried organic semiconductor film 10 is matured on a substrate or a first stamp 15, whereby on a surface 12 not contacting the substrate or first stamp, i.e., on a surface 12 exposed to the ambient atmosphere, the organic semiconductor material in the undried organic semiconductor film can be reoriented owing to its crystallinity, self-organizing property or the like.

More specifically, during the maturing, on the surface 12 not contacting the substrate or first stamp 15, the organic semiconductor material in the undried organic semiconductor film 10 is less likely to be affected by the surface of the substrate or first stamp 15, and therefore can be reoriented due to crystallinity or the like of the organic semiconductor material.

Also, during the maturing, on the surface 11 contacting the substrate or first stamp 15, due to a small water contact angle on the surface of the substrate or first stamp 15, i.e., a small surface energy on the surface of the substrate or first stamp 15, the organic semiconductor material in the undried organic semiconductor film 10 is less likely to be affected by the surface of the substrate or first stamp 15, despite contact with the surface of the substrate or first stamp 15, and therefore can be reoriented due to crystallinity or the like of the organic semiconductor material.

In other words, in the method of the first aspect of the present invention, the organic semiconductor material can be reoriented due to crystallinity or the like of the organic semiconductor material on both of two opposing surfaces 11 and 12, so that an organic semiconductor film having low charge mobility on both of these surfaces 11 and 12 and a large degree of crystallization over the entire thickness can be obtained.

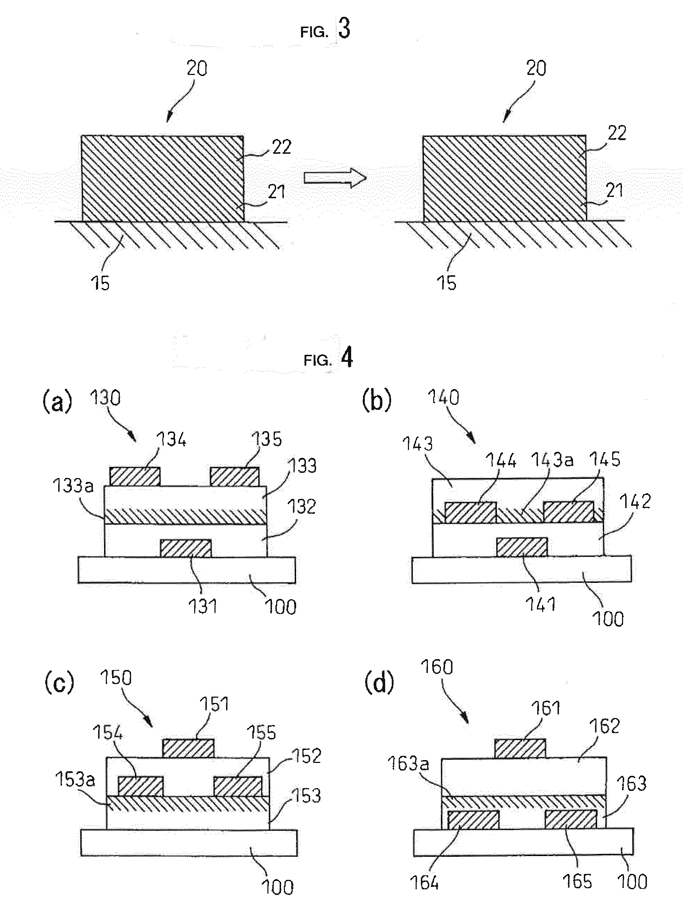

On the other hand, in the conventional method for producing an organic semiconductor film, as shown in Fig. 3, the organic semiconductor solution is dried immediately after applying the organic semiconductor solution on a substrate or a first stamp 15, and therefore it is difficult for the organic semiconductor material to be reoriented not only on the surface 21 contacting the substrate or first stamp 15 but also on the surface 22 not contacting the substrate or first stamp 15. For this reason, in the conventional method, a semiconductor film having a small difference in the charge mobility between two opposing surfaces 21 and 22 but having a small degree of crystallization over the entire thickness is obtained.

### «Method of Second Aspect of the Present Invention for Producing Organic Semiconductor Film»

The method of the second aspect of the present invention for producing an organic semiconductor film comprises providing an organic semiconductor solution comprising an organic semiconductor material dissolved and/or dispersed therein, applying the organic semiconductor solution on a substrate or a first stamp to obtain an undried organic semiconductor film, and maturing the undried organic semiconductor film on the substrate or first stamp.

According to the method of the second aspect of the present invention for producing an organic semiconductor film, the organic semiconductor film of the second aspect of the present invention, i.e., an organic semiconductor film having a large difference in the charge mobility between two opposing surfaces, can be produced.

Specifically, according to the method of the second aspect of the present invention for producing an organic semiconductor film, as shown in Fig. 2, an undried organic semiconductor film 10 is matured on a substrate or a first stamp 15, whereby on a surface 12 not contacting the substrate or first stamp, i.e., on a surface 12 exposed to the ambient atmosphere, the organic semiconductor material in the undried organic semiconductor film can be reoriented due to its crystallinity, self-organizing property or the like.

More specifically, during the maturing, on the surface 11 contacting the substrate or first stamp 15, reorientation of the organic semiconductor material in the undried organic semiconductor film 10 is sometimes restricted by the effect of the surface of the substrate or first stamp 15, particularly, by the affinity for the surface of the substrate or first stamp 15. In contrast, on the surface 12 not contacting the substrate or first stamp 15, the organic semiconductor material in the undried organic semiconductor film is less likely to be affected by the surface of the substrate or first stamp 15, and therefore can be reoriented due to crystallinity or the like of the organic semiconductor material. That is, in the method of the second aspect of the present invention, an organic semiconductor film having a large difference in the charge mobility between two opposing surfaces 11 and 12 is obtained.

On the other hand, in the conventional method for producing an organic semiconductor film, as shown in Fig. 3, the organic semiconductor solution is dried immediately after applying the organic semiconductor solution on a substrate or a first stamp 15, and the organic semiconductor material cannot be reoriented not only on the surface 21 contacting the substrate or first stamp 15 but also on the surface 22 not contacting the substrate or first stamp 15. For this reason, in the conventional method, a semiconductor film having a small difference in the charge mobility between two opposing surfaces 21 and 22 is obtained.

### «Methods of First and Second Aspects for Producing Organic Semiconductor Film - Organic Semiconductor Material and Solvent»

As for the organic semiconductor material used in the method of the present invention, descriptions on the semiconductor film of the present invention may be referred to.

The solvent contained in the organic semiconductor solution used in the method of the present invention may be an arbitrary solvent in which an organic semiconductor material can be dissolved and/or dispersed. Examples of the solvent include toluene, xylene, tetralin, decalin, chloroform, monochlorobenzene, dichlorobenzene, trichlorobenzene, and a combination thereof.

### «Methods of First and Second Aspects for Producing Organic Semiconductor Film - Substrate and First Stamp»

The substrate on which the organic semiconductor solution is applied in the methods of the first and second aspects of the present invention may be an arbitrary substrate intended to dispose an organic semiconductor film thereon. Accordingly, examples of the substrate include an inorganic material such as silicon wafer and glass, and an organic material such as polymer film.

The first stamp on which the organic semiconductor solution is applied in the method of the present invention may be an arbitrary stamp enabling formation of an organic semiconductor film thereon and allowing transfer of the semiconductor film onto a substrate or the like therefrom, i.e., may be a contact printing stamp for the formation of an organic semiconductor film. Such a first stamp can be formed of, for example, polysiloxane. Also, the first stamp may be, for example, the later-described stamp of the third aspect of the present invention having a transfer part-peripheral part structure.

The substrate or first stamp on which the organic semiconductor solution is applied in the method of the first aspect of the present invention has a surface having a relatively large water contact angle, i.e., a surface having a water contact angle of, for example, 100° or more, or 105° or more. Also, the substrate or first stamp on which the organic semiconductor solution is applied in the method of the second aspect of the present invention may have a surface having a relatively large water contact angle, i.e., a surface having a water contact angle of, for example, 40° or more, 50° or more, 60° or more, 70° or more, 80° or more, 90° or more, 100° or more, or 105° or more. When the water contact angle on the substrate surface is relatively high as above, this means that the surface is relatively hydrophobic, namely, the surface energy of the surface is relatively low.

Incidentally, the water contact angle as used in the present invention can be determined by dropping 50 µl of water at 25°C on a surface to be measured for contact angle, observing the shape of the dropped droplet from the lateral side, and measuring the angle between the droplet and the surface.

In this way, when the substrate or first stamp on which the organic semiconductor solution is applied in the method of the present invention has a surface with low surface energy, the organic semiconductor material in the undried organic semiconductor film is less likely to be affected by the surface of the substrate or first stamp even on the surface contacting the substrate or first stamp, and therefore can be reoriented due to crystallinity or the like of the organic semiconductor material itself.

The substrate or first stamp having a surface with a relatively large water contact angle can be obtained, for example, by treating the surface of a substrate or a first stamp with a hydrophobic material. Examples of the hydrophobic material include silane, silazane, a fluorine compound, polyimide, polyester, polyethylene, polyphenylene sulfide, polyparaxylene, polyethylene terephthalate, polyethylene naphthalate, polydimethylsiloxane, and a combination thereof.

### «Methods of First and Second Aspects of the Present Invention for Producing Organic Semiconductor Film - Application»

In the methods of the first and second aspects of the present invention for producing an organic semiconductor film, an arbitrary method such as casting method, spin coating method and dipping method may be used to apply the organic semiconductor solution on the substrate or first stamp.

### «Methods of First and Second Aspects of the Present Invention for Producing Organic Semiconductor Film - Maturing»

The maturing in the methods of the first and second aspects of the present invention for producing an organic semiconductor film can be performed, for example, by holding the undried organic semiconductor film over 10 seconds or more, 30 seconds or more, 1 minute or more, 3 minutes or more, 5 minutes or more, or 7 minutes or more. The maturing in the method of the present invention can be performed, for example, by keeping the undried organic semiconductor film in an undried state over a predetermined time of period before drying and/or thermal annealing the organic semiconductor film.

Also, the maturing in the method of the present invention can be performed, for example, by holding the undried organic semiconductor film in an atmosphere having a temperature of less than 50°C, less than 40°C, or less than 30°C. Maturing of the undried organic semiconductor film at a relatively low temperature is sometimes preferred so as to keep the organic semiconductor film from drying and in turn, accelerate reorientation of the organic semiconductor material on the surface not contacting the substrate or first stamp.

However, the conditions necessary for maturing, such as time and temperature, are dependent on, for example, the semiconductor material, solvent, substrate or first stamp used, and one skilled in the art can determine these conditions in accordance with descriptions of the present invention.

Incidentally, in the method of the present invention for producing an organic semiconductor film, the "undried organic semiconductor film" means that the semiconductor film contains a solvent to such an extent as allowing the organic semiconductor material in the organic semiconductor film to be reoriented due to crystallinity or the like of the organic semiconductor material.

### «Methods of First and Second Aspects of the Present Invention for Producing Organic Semiconductor Film - Drying»

The methods of first and second aspects of the present invention for producing an organic semiconductor film may optionally further comprise drying and/or thermal annealing the organic semiconductor layer matured on the substrate or first stamp. The drying and thermal annealing can be performed by exposing the matured organic semiconductor layer to an atmosphere having a temperature of more than 40°C, more than 50°C, more than 70°C, or more than 100°C. The drying may be also performed by removing the solvent from the organic semiconductor solution under reduced pressure.

### «Methods of First and Second Aspects of the Present Invention for Producing Organic Semiconductor Film - Transfer»

In the case of applying and maturing the organic semiconductor solution on a first stamp in the method of the present invention for producing an organic semiconductor film, the method of the present invention may further comprise transferring the organic semiconductor layer matured on the first stamp, for example, transferring the organic semiconductor layer onto a substrate or a second stamp.

More specifically, in this case, the organic semiconductor film formed on the first stamp can be transferred, for example, directly onto a substrate such as silicon wafer and polymer film. Also, in this case, the organic semiconductor film formed on the first stamp can be transferred onto a second stamp and then transferred onto a substrate from the second stamp.

Incidentally, transfer of the organic semiconductor film onto a substrate or a second stamp from the first stamp can be attained by bringing the first stamp holding the organic semiconductor film into contact with a substrate or a second stamp. The transfer conditions such as contact time and temperatures of first stamp and substrate, can be arbitrarily determined to enable transfer.

Specifically, the transfer may be performed by setting the temperature of the substrate or second stamp to be higher than the temperature of the first stamp. Also, the transfer may be attained by treating the surface of the first stamp to reduce the adhesive property to the organic semiconductor film and/or treating the surface of the substrate or second stamp to increase the adhesive property to the semiconductor film. Furthermore, the transfer may be attained by a combination of these techniques.

The second stamp used in the method of the present invention may be an arbitrary stamp capable of receiving transfer of the organic semiconductor film formed on the first stamp and allowing transfer of the semiconductor film onto a substrate or the like therefrom, i.e., may be a contact printing stamp. Such a second stamp can be formed of, for example, polysiloxane. Also, transfer of the organic semiconductor film from the second stamp onto a substrate may be performed as described on the transfer of the organic semiconductor film from the first stamp onto a substrate or a second stamp.

### «Organic Semiconductor Device»

The organic semiconductor devices of the first and second aspects of the present invention have the organic semiconductor films of the first and second aspects of the present invention, respectively. Incidentally, the "organic semiconductor device" as used in the present invention is a device having an organic semiconductor film, and other layers such as electrode layer and dielectric layer may be formed of either an inorganic material or an organic material.

The organic semiconductor devices of the first and second aspects of the present invention may be, for example, a thin-film transistor having the organic semiconductor film of the first or second aspects of the present invention. For example, as shown in Fig. 4, the thin-film transistor of the present invention may be any of (a) a bottom-gate top-contact type (BGTC type), (b) a bottom-gate bottom-contact type (BGBC type), (c) a top-gate top-contact type (TGTC type), and (d) a top-gate bottom-contact type (TGBC type). These thin-film transistors 130, 140, 150 and 160 of the present invention have a source electrode 134, 144, 154 or 164, a drain electrode 135, 145, 155 or 165, a gate electrode 131, 141, 151 or 161, a gate insulating film 132, 142, 152 or 162, and a semiconductor film 133, 143, 153 or 163, where the source electrode and the drain electrode are insulated from the gate electrode by a gate insulating film and at the same time, the current flowing from the source electrode to the drain electrode through the semiconductor film is controlled by the voltage applied to the gate electrode.

In the case where the organic semiconductor devices of the first and second aspects of the present invention are a thin-film transistor and the organic semiconductor layer of the thin-film transistor is obtained by a contact printing method, the thin-film transistor may be particularly a bottom-contact thin-film transistor, i.e., a bottom-gate bottom-contact (BGBC-type) or top-gate bottom-contact (TGBC-type) thins-film transistor.

In the case of manufacturing a bottom-contact thin-film transistor by the conventional spin coating method, because there is a difference in the surface energy between surfaces of the metal electrode and dielectric material present on the substrate, orientation disorder is produced in the organic transistor formed particularly in the vicinity of the electrode/dielectric material interface. In turn, the contact resistance between the electrode and the organic semiconductor layer tends to be increased.

On the other hand, in the case of manufacturing a bottom-contact thin-film transistor by a contact printing method, an organic semiconductor layer is formed on a stamp, and then, the organic semiconductor layer is transferred onto a substrate having an electrode, so that the problem as encountered in the spin coating method can be eliminated. Accordingly, in the bottom-contact thin film transistor, it is very advantageous to form the organic semiconductor layer by a contact printing method.

Also, the organic semiconductor devices of the first and second aspects of the present invention may be, for example, a solar cell having the organic semiconductor film of the present invention. The solar cell has, for example, a structure where a p-type semiconductor and an n-type semiconductor are joined, and the organic semiconductor film of the present invention is used as at least one of these p-type and n-type semiconductors.

### «Electric Circuit»

The electric circuit of the present invention is an electric circuit comprising a circuit substrate having on one surface thereof two or more thin-film transistors of the second aspect of the present invention.

In the electric circuit of the present invention, as shown in Fig. 4, an organic semiconductor film 133 or 143 is disposed by arranging the surface 133a or 143a with high charge mobility of the semiconductor film 133 or 143 to face the circuit substrate in at least one 130 or 140 of the thin-film transistors of the second aspect of the present invention on one surface of a circuit substrate 100 such as silicon wafer and polymer film and at the same time, this surface 133a or 143a serves as the active surface in the thin-film transistor of the second aspect, i.e., as the surface in which a channel for a carrier is formed. In other words, for example, in the electric circuit of the present invention, at least one of the thin-film transistors of the second aspect on one surface of a circuit substrate 100 is a bottom-gate thin-film transistor 130 or 140.

Also, in the electric circuit of the present invention, as shown in Fig. 4, an organic semiconductor film 153 or 163 is disposed by arranging the surface 153a or 163a with high charge mobility of the semiconductor film 153 or 163 to face the opposite side of the circuit substrate 100 in at least another one 150 or 160 of the thin-film transistors of the second aspect of the present invention and at the same time, this surface 153a or 163a serves as the active surface in the thin-film transistor. In other words, for example, in the electric circuit of the present invention, at least one of the thin-film transistors on one surface of a circuit substrate 100 is a top-gate thin-film transistor 150 or 160.

Accordingly, in the case where the electric circuit of the present invention has a plurality of thin-film transistors of the second aspect of the present invention, the surface of the organic semiconductor layer working out to the active surface in each transistor is the surface with high charge mobility. That is, in the case where the electric circuit of the present invention has a plurality of thin-film transistors of the second aspect of the present invention, the organic semiconductor film can provide high charge mobility in each thin-film transistor.

The organic semiconductor film for such an electric circuit of the present invention can be obtained using the method of the second aspect of the present invention for producing the organic semiconductor film of the second aspect of the present invention.

More specifically, for example, in the case of manufacturing the thin-film transistor of the second aspect of the present invention where the surface with high charge mobility of the organic semiconductor film faces the circuit substrate, i.e., in the case of manufacturing, for example, a bottom-gate thin-film transistor 130 or 140 shown in Fig. 4, after maturing the undried organic semiconductor film on the first stamp in the method of the second aspect of the present invention for producing an organic semiconductor film, the obtained organic semiconductor film is transferred onto a circuit substrate, whereby the surface with high charge mobility of the organic semiconductor film can be arranged to face the circuit substrate.

Also, for example, in the case of manufacturing the thin-film transistor of the second aspect of the present invention where the surface with high charge mobility of the organic semiconductor film faces the opposite side of the circuit substrate, i.e., in the case of manufacturing, for example, a top-gate thin-film transistor 150 or 160 shown in Fig. 4, after maturing the undried organic semiconductor film on the first stamp in the method of the second aspect of the present invention for producing an organic semiconductor film, the obtained organic semiconductor film is transferred onto a second stamp, and then transferred onto a circuit substrate, whereby the surface with high charge mobility of the organic semiconductor film can be arranged to face the opposite side of the circuit substrate. Also, in this case, by maturing the undried organic semiconductor film on a circuit substrate in the method of the second aspect of the present invention for producing an organic semiconductor, the surface with high charge mobility of the organic semiconductor film can be arranged to face the opposite side of the circuit substrate.

### «Stamp of the Present Invention Having Transfer Part-Peripheral Part Structure»

In the methods of the first and second aspects of the present invention, the below-described stamp of the present invention having a transfer part-peripheral part structure may be used as the first and second stamps.

The stamp of the present invention having a transfer part-peripheral part structure has a transfer part for holding an organic semiconductor film to be transferred, and a peripheral part surrounding the transfer part, wherein the water contact angle of the transfer part is larger by 20° or more, 30° or more, 40° or more, 50° or more, 60° or more, 70° or more, 80° or more, 90° or more, or 100° or more, than the water contact angle of the peripheral part.

In the case where the stamp of the present invention having a transfer part-peripheral part structure is used in the method of the first aspect of the present invention for producing an organic semiconductor film, the water contact angle of, for example, the transfer part may be 105° or more, or 110° or more. Also, in the case where the stamp of the present invention having a transfer part-peripheral part structure is used in the method of the second aspect of the present invention for producing an organic semiconductor film, the water contact angle of, for example, the transfer part may be 40° or more, 50° or more, 70° or more, 90° or more, 95° or more, 100° or more, 105° or more, or 110° or more.

That is, the stamp having a transfer part-peripheral part structure is a contact printing stamp in which the transfer part is more hydrophobic than the peripheral part. The "hydrophobic" means that the surface energy is low, and therefore the stamp having a transfer part-peripheral part structure can be said to be a contact printing stamp in which the surface energy of the transfer part is low and the surface energy of the peripheral part is high.

In the case of forming an organic semiconductor film from an organic semiconductor solution on the transfer part of the stamp having a transfer part-peripheral part structure, due to the presence of a hydrophilic peripheral part in the periphery of the hydrophobic transfer part, a film of the organic semiconductor solution can be held on the surface of the transfer part that is relatively hard to be wetted, and thereby formation of an organic semiconductor film from the organic semiconductor solution on the surface of the transfer part can be accelerated on the surface of the transfer part. That is, according to this stamp, an organic semiconductor film can be formed even on the surface of the transfer part that is relatively hard to be wetted.

In the case of forming an organic semiconductor film from an organic semiconductor solution on the transfer part of the stamp having a transfer part-peripheral part structure, the organic semiconductor molecule can be oriented on the surface contacting the transfer part by the action between organic semiconductor molecules since the molecule are relatively free from the effect of the surface of the transfer part. That is, according to the stamp having a transfer part-peripheral part structure, an organic semiconductor film with high charge mobility can be obtained on the surface contacting the transfer part when forming an organic semiconductor film from an organic semiconductor solution.

On the other hand, the transfer part of a general contact printing stamp is usually made hydrophilic so as to improve wettability thereon with the organic semiconductor solution, and thereby enable stable formation of a film of the organic semiconductor solution. Accordingly, in the case of forming an organic semiconductor film from an organic semiconductor solution on the transfer part of a general contact printing stamp, the organic semiconductor molecule on the surface contacting the transfer part is affected by the transfer part, and therefore can be hardly oriented by the action between organic semiconductor molecules. That is, with a general contact printing stamp, an organic semiconductor film having high charge mobility cannot be obtained on the surface contacting the transfer part when forming an organic semiconductor film from an organic semiconductor solution.

Furthermore, in the case of forming an organic semiconductor film from an organic semiconductor solution on the transfer part of the stamp having a transfer part-peripheral part structure, adhesion of the obtained organic semiconductor film to the transfer part is relatively weak, so that the organic semiconductor film can be transferred onto the surface of a relatively hydrophobic substrate, for example, onto the surface of a substrate having a water contact angle of 50° or more.

On the other hand, as described above, the transfer part of a conventional contact printing stamp is generally made hydrophilic. Accordingly, in the case of forming an organic semiconductor film from an organic semiconductor solution on the transfer part of a conventional contact printing stamp, adhesion of the organic semiconductor film to the transfer part is relatively strong, and therefore the organic semiconductor film can be hardly transferred onto the surface of a relatively hydrophobic substrate, for example, onto the surface of a substrate having a water contact angle of 50° or more.

The stamp having a transfer part-peripheral part structure may be an arbitrary contact printing stamp enabling formation of an organic semiconductor film thereon and allowing transfer of the semiconductor film onto a substrate or the like. Such a first stamp can be formed of, for example, polysiloxane.

In the case of using polysiloxane as the material for the stamp having a transfer part-peripheral part structure, a hydrophobic polysiloxane is prepared and while a hydrophilization (lipophilization) treatment is applied to the surface corresponding to the peripheral part, such a treatment is not applied to the portion corresponding to the transfer part, whereby a stamp having a transfer part-peripheral part structure can be obtained. Conversely, a hydrophilic stamp material is prepared and while a hydrophobization (lipophobication) treatment is applied to the surface corresponding to the transfer part, such a treatment is not applied to the portion corresponding to the peripheral part, whereby a stamp having a transfer part-peripheral part structure can be obtained. Furthermore, a stamp material is prepared and while a hydrophilization treatment is applied to the surface corresponding to the peripheral part, a hydrophobization treatment is applied to the surface corresponding to the transfer part, whereby a stamp having a transfer part-peripheral part structure can be obtained.

Specifically, in order to obtain a hydrophobic transfer part in the stamp having a transfer part-peripheral part structure, the area corresponding to the transfer part on the surface of the stamp can be treated with a hydrophobic material. Examples of the hydrophobic material include silane, silazane, a fluorine compound, polyimide, polyester, polyethylene, polyphenylene sulfide, polyparaxylene, polyethylene terephthalate, polyethylene naphthalate, polydimethylsiloxane, and a combination thereof.

In order to obtain a hydrophilic peripheral part in the stamp having a transfer part-peripheral part structure, for example, the area corresponding to the peripheral part on the surface of the stamp can be treated with ozone, ultraviolet light, electron beam, plasma or the like, or the part may be formed of a hydrophilic material.

The stamp having a transfer part-peripheral part structure can have such an arbitrary shape and an arbitrary dimension as enabling formation of an organic semiconductor film suitable for the intended use. Accordingly, in the stamp having a transfer part-peripheral part structure, the size of one transfer part may be from 0.01 to 1,000,000 µm², from 0.1 to 100,000 µm², or from 1 to 10,000 µm².

The stamp having a transfer part-peripheral part structure may have an arbitrary shape and an arbitrary structure as long as the peripheral part makes it possible to hold an organic semiconductor solution on the transfer part and at the same time, the organic semiconductor film formed on the transfer part can be transferred onto a second stamp or a substrate. Accordingly, in the stamp having a transfer part-peripheral part structure, the transfer part and the peripheral part may be on the same plane, or the transfer part may be concaved with respect to the peripheral part. Also, in the stamp having a transfer part-peripheral part structure, the area for holding an organic semiconductor solution to form an organic semiconductor film may be convexed, and the convexed part may have a transfer part and a peripheral part surrounding the transfer part.

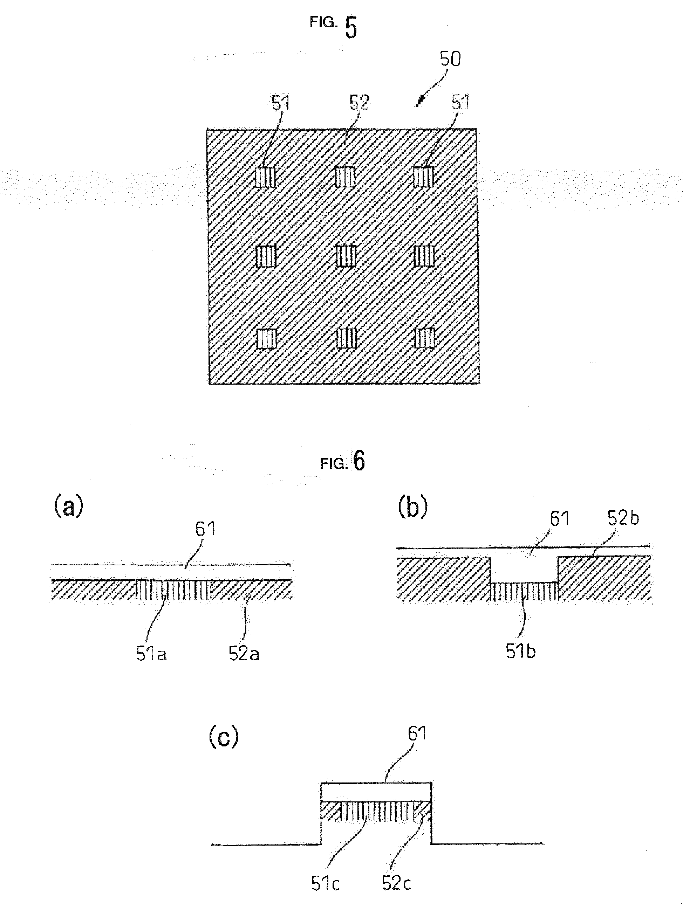

Such a stamp is, for example, a stamp shown in Fig. 5. The stamp 50 shown in Fig. 5 has 9 transfer parts 51 corresponding to the organic semiconductor film to be transferred. In the periphery of individual transfer parts 51, a peripheral part 52 for holding the organic semiconductor film to be transferred is present.

Specifically, as shown in Fig. 6(a), in the stamp having a transfer part-peripheral part structure, the transfer part 51a and the peripheral part 52a may be on the same plane. In this case, due to affinity between the peripheral part 52a and the organic semiconductor solution 61, holding of an organic semiconductor solution 61 on the transfer part 51a can be facilitated.

Also, in the stamp having a transfer part-peripheral part structure, as shown in Fig. 6(b), the transfer part 51b may be concaved with respect to the peripheral part 52b. In this case, coupled with affinity between the peripheral part 52b and the organic semiconductor solution 61, due to steric formed by the peripheral part 52b, holding of an organic semiconductor solution 61 on the transfer part 51b can be facilitated.

Furthermore, in the stamp having a transfer part-peripheral part structure, as shown in Fig. 6(c), the transfer part 51c and the peripheral part 52c may be convexed with respect to other portions. In this case, due to affinity between the peripheral part 52c and the organic semiconductor solution 61, holding of an organic semiconductor solution 61 on the transfer part 51c can be facilitated, and the organic semiconductor solution 61 can be held in the form corresponding to the shape of the transfer part 51c and the peripheral part 52c. Incidentally, in this case, the portion other than the convexed transfer part 51c and peripheral part 52c, i.e., the concaved part, may have high or low affinity for the organic semiconductor solution 61, but when the affinity for the organic semiconductor 61 is low, the organic semiconductor solution 61 can be kept from being held in the concaved part.

The method for producing an organic semiconductor film by using a stamp having a transfer part-peripheral part structure comprises providing an organic semiconductor solution containing a solvent and an organic semiconductor material dissolved and/or dispersed in the solvent, and applying the organic semiconductor solution on the transfer part of the stamp having a transfer part-peripheral part structure to form an organic semiconductor film.

### EXAMPLES

The present invention is described in detail below by referring to Examples, but the present invention is not limited thereto. Evaluation methods used in Examples are as follows.

### Water Contact Angle:

The water contact angle was measured with pure water at 25°C by using a water contact angle meter, Model CA-X, manufactured by Kyowa Interface Science Co., Ltd.

### Relative X-Ray Reflection Peak Height:

The peak height of X-ray symmetric reflection was measured on the organic semiconductor layer by using RINT TTR II manufactured by Rigaku Corporation under the conditions of an X-ray source of Cu-Kα ray and a rotating anticathode of 50 kV-300 mA (15 kW). This peak height was standardized for the same thickness based on the peak height measured on an organic semiconductor film of the material produced on a silicon wafer by spin coating (in accordance with Example 12 (Comparison)), and the peak height was evaluated by the relative height. When the value of the relative X-ray reflection peak height is large, this means that the degree of crystallization over the entire thickness of the organic semiconductor film is large.

Incidentally, in the organic semiconductor film of regioregular poly(3-hexylthiophene) ("P3HT"), the peak height of symmetric reflection on (100) plane was measured. In this connection, in the following Examples, the X-ray reflection peak height was evaluated on an organic semiconductor film obtained by one transfer, but the same value as in one transfer is obtained also in the case of two transfers.

### Charge Mobility:

The charge mobility of the organic semiconductor film was evaluated using a semiconductor evaluation apparatus, Model 4200-SCS, manufactured by Keithley. Also, the standard deviation of the charge mobility was calculated by evaluating the characteristics of 10 or more devices.

### «Examples 1 to 13»

In Examples 1 to 13, a bottom-gate top-contact (BGTC-type) transistor was fabricated.

### «Example 1»

### (Production of Contact Printing Stamp)

A material obtained by curing silicone rubber (SIM-260, produced by Shin-Etsu Chemical Co., Ltd.) in a plate form and removing oligomers with use of hexane was provided as a stamp material.

The stamp material was cut into a 20-mm square, and a mask corresponding to the transfer part was put on this stamp material to mask the transfer part. The stamp material having the thus-masked transfer part was subjected to UV (ultraviolet ray)-ozone treatment over 30 minutes. That is, UV-ozone treatment was not applied to the transfer part and UV-ozone treatment was applied to the peripheral part. By this UV-ozone treatment, a hydrophilic surface was provided to the peripheral part.

The water contact angle of the transfer part not subjected to UV-ozone treatment was 110°, and the water contact angle of the peripheral part subjected to UV-ozone treatment for 30 minutes was 44°. On the stamp, 12 transfer parts were present, and the size of individual transfer parts was 100 µm×20 mm.

### (Inking of Organic Semiconductor)

1 part by mass of regioregular poly(3-hexylthiophene) ("P3HT") (sold by Aldrich, Plexcore OS1100 produced by Plextronics Inc., MW=25,000 to 35,000) was dissolved in 99 parts by mass of toluene to obtain a P3HT solution as an organic semiconductor solution. This P3HT solution was spin-coated (1,800 rpm, 20 seconds) on the pattern-formed stamp material, and then the stamp was left standing for about 10 minutes to mature and dry the P3HT solution, whereby an organic semiconductor film was formed on the stamp.

### (Silicon Substrate)

An n-type silicon wafer (plane orientation: <100>, specific resistance: 0.05 Ω) with a 300 nm-thick thermal oxide film was treated with hot concentrated sulfuric acid for 30 minutes and then ultrasonically washed several times in each of pure water, acetone, toluene and hexane. The silicon wafer was further washed in an UV-ozone cleaning apparatus for 30 minutes and used as the substrate. The water contact angle on the surface of the silicon wafer was 4°.

### (One Transfer)

The stamp having an organic semiconductor film was fixed to a roller to obtain a stamp-attached roller. A silicon substrate is heated/kept at 75°C, and the stamp-attached roller was contacted with and rotated on the substrate to transfer the entire organic semiconductor film onto the substrate.

### (Manufacture of Thin-Film Transistor)

Gold was vacuum-deposited on the portion corresponding to the transfer part of the obtained organic semiconductor film by a mask vapor deposition method to form a source electrode and a drain electrode (L/w=50 µm/1.5 mm), whereby a thin-film transistor using the silicon substrate as the gate electrode and using the oxide film on the silicon substrate surface as the gate insulating film was obtained. That is, a thin-film transistor having a configuration shown by 130 in Fig. 4 was obtained.

The thus-obtained thin-film transistor, that is, a thin-film transistor in which the surface located on the air side at the film production serves as the active surface, was measured for the charge mobility and the X-ray reflection peak height. The results are shown in Table 1.

### (Two Transfers)

Also, in place of manufacturing a thin film-transistor through one transfer, in which the surface located on the air side at the film production serves as the active surface, a thin-film transistor in which the surface located on the stamp side at the film production serves as the active surface was manufactured through two transfers.

Specifically, the organic semiconductor film was transferred onto a second stamp (first transfer) in place of a silicon substrate. Thereafter, the second stamp having transferred thereon the organic semiconductor film was fixed to a roller and was contacted with and rotated on a silicon substrate heated/kept at 75°C to transfer the organic semiconductor film onto the substrate (second transfer). As the second stamp, a stamp material treated in the same manner as the transfer part of the first stamp was used. That is, the treatment was performed such that the water contact angle on the surface of the second stamp became the same as the water contact angle on the surface of the transfer part of the first stamp.

The thus-obtained thin-film transistor, that is, a thin-film transistor in which the surface located on the stamp side at the film production serves as the active surface, was measured for the charge mobility. The result is shown in Table 1.

### «Example 2»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 2 minutes.

The water contact angle of the transfer part subjected to UV-ozone treatment for 2 minutes was 107°, and the water contact angle of the peripheral part subjected to UV-ozone treatment for 32 minutes in total was 40°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility. The result is shown in Table 1.

Also, a thin-film transistor was manufactured through two transfers in the same manner as in Example 1. The thus-obtained thin-film transistor, i.e., a thin-film transistor in which the surface located on the stamp side at the film production serves as the active surface, was measured for the charge mobility. The result is shown in Table 1.

### <<Example 2A>>

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 2.5 minutes.

The water contact angle of the transfer part subjected to UV-ozone treatment for 2 minutes was 105°, and the water contact angle of the peripheral part subjected to UV-ozone treatment for 32 minutes in total was 39°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility. The result is shown in Table 1.

Also, a thin-film transistor was manufactured through two transfers in the same manner as in Example 1. The thus-obtained thin-film transistor, i.e., a thin-film transistor in which the surface located on the stamp side at the film production serves as the active surface, was measured for the charge mobility. The result is shown in Table 1.

### «Example 3»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 3 minutes.

The water contact angle of the transfer part subjected to UV-ozone treatment for 3 minutes was 104°, and the water contact angle of the peripheral part subjected to UV-ozone treatment for 33 minutes in total was 37°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility. The result is shown in Table 1.

Also, a thin-film transistor was manufactured through two transfers in the same manner as in Example 1. The thus-obtained thin-film transistor, i.e., a thin-film transistor in which the surface located on the stamp side at the film production serves as the active surface, was measured for the charge mobility. The result is shown in Table 1.

### «Example 4»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 5 minutes.

The water contact angle of the transfer part subjected to UV-ozone treatment for 5 minutes was 99°, and the water contact angle of the peripheral part subjected to UV-ozone treatment for 35 minutes in total was 33°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility. The result is shown in Table 1.

Also, a thin-film transistor was manufactured through two transfers in the same manner as in Example 1. The thus-obtained thin-film transistor, i.e., a thin-film transistor in which the surface located on the stamp side at the film production serves as the active surface, was measured for the charge mobility. The result is shown in Table 1.

### «Example 5»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 10 minutes.

The water contact angle of the transfer part subjected to UV-ozone treatment for 10 minutes was 95°, and the water contact angle of the peripheral part subjected to UV-ozone treatment for 40 minutes in total was 21°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility and the X-ray reflection peak height. The results are shown in Table 1.

Also, a thin-film transistor was manufactured through two transfers in the same manner as in Example 1. The thus-obtained thin-film transistor, i.e., a thin-film transistor in which the surface located on the stamp side at the film production serves as the active surface, was measured for the charge mobility. The result is shown in Table 1.

### «Example 6»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 20 minutes.

The water contact angle of the transfer part subjected to UV-ozone treatment for 20 minutes was 72°, and the water contact angle of the peripheral part subjected to UV-ozone treatment for 50 minutes in total was 4°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility and the X-ray reflection peak height. The results are shown in Table 1.

Also, a thin-film transistor was manufactured through two transfers in the same manner as in Example 1. The thus-obtained thin-film transistor, i.e., a thin-film transistor in which the surface located on the stamp side at the film production serves as the active surface, was measured for the charge mobility. The result is shown in Table 1.

### «Example 7»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 30 minutes.

The water contact angle of the transfer part subjected to UV-ozone treatment for 30 minutes was 44°, and the water contact angle of the peripheral part subjected to UV-ozone treatment for 60 minutes in total was 4°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility. The result is shown in Table 1.

Also, an attempt was made to manufacture a thin-film transistor in which the surface located on the stamp side at the film production serves as the active surface, through two transfers in the same manner as in Example 1. However, in this Example, transfer from the stamp above to a second stamp was not successfully performed, and therefore a thin-film transistor in which the surface located on the stamp side at the film production serves as the active surface, could not be manufactured.

### «Example 8»

### (Production of Contact Printing Stamp)

The stamp material was cut into a 20-mm square, and a mask corresponding to the transfer part was put on this stamp material to mask the transfer part. The stamp material having the thus-masked transfer part was subjected to UV-ozone treatment over 30 minutes. That is, UV-ozone treatment was not applied to the transfer part and UV-ozone treatment was applied to the peripheral part. Subsequently, the mask was removed, and UV-ozone treatment was applied to the entire stamp, namely, both the transfer part and the peripheral part, over 45 minutes.

The water contact angle of the transfer part subjected to UV-ozone treatment for 45 minutes was 8°, and the water contact angle of the peripheral part subjected to UV-ozone treatment for 75 minutes in total was 4°.

### (Manufacture of Thin-Film Transistor)

Using the thus-obtained stamp, a thin-film transistor in which the surface located on the air side at the film production serves as the active surface, was manufactured through one transfer in the same manner as in Example 1. The obtained thin-film transistor was measured for the charge mobility. The result is shown in Table 1.

Also, an attempt was made to manufacture a thin-film transistor in which the surface located on the stamp side at the film production serves as the active surface, through two transfers in the same manner as in Example 1. However, in this Example, transfer from the stamp above to a second stamp was not successfully performed, and therefore a thin-film transistor in which the surface located on the stamp side at the film production serves as the active surface, could not be manufactured.

### «Example 9»

Using the stamp obtained in the same manner as in Example 1, a thin-film transistor in which the surface located on the air side at the film production serves as the active surface, was manufactured through one transfer in the same manner as in Example 1. However, in this Example, a F8T2 solution obtained as follows was used as the organic semiconductor solution in place of the P3HT solution. The obtained thin-film transistor was measured for the charge mobility. The result is obtained in Table 1.

The F8T2 solution as the organic semiconductor solution was obtained by dissolving 0.5 parts by mass of poly[(9,9'-dioctylfluorenyl-2,7-diyl)-co-bithiophene] ("F8T2") (produced by American Dye Source Inc.) in 99.5 parts by mass of toluene.

Also, a thin-film transistor was manufactured through two transfers in the same manner as in Example 1. The thus-obtained thin-film transistor, that is, a thin-film transistor in which the surface located on the stamp side at the film production serves as the active surface, was measured for the charge mobility. However, in the organic semiconductor layer obtained in this Example, meaningful semiconductor characteristics were not observed. The result is shown in Table 1.

### <<Example 10 (Comparison)>>

A thin-film transistor in which the surface located on the air side at the film production serves as the active surface, was manufactured through one transfer in the same manner as in Example 1, except that the P3HT solution was applied on the stamp by spin coating and without maturing, immediately transferred onto a substrate. The obtained thin-film transistor was measured for the charge mobility. The result is shown in Table 1.

### <<Example 11 (Comparison)>>

The stamp material was cut into a 20-mm square and directly used without applying surface treatment. The water contact angle on the surface of the stamp here was 110°. The P3HT solution was spin-coated on the stamp surface in the same manner as in Example 1, but because the entire stamp surface was hydrophobic, an organic semiconductor film could not be stably formed on the stamp surface.

### <<Example 12 (Comparison)>>

The P3HT solution used in Example 1 was spin-coated (1,800 rpm, 20 seconds) directly on the silicon substrate used in Example 1. That is, a semiconductor film was formed directly on the substrate without using a stamp.

A source electrode and a drain electrode were formed on the obtained organic semiconductor film in the same manner as in Example 1 to obtain a thin-film transistor.

The thus-obtained thin-film transistor, i.e., a thin-film transistor in which the active surface of the organic semiconductor layer was not subjected to a maturing step in the state of facing air, was measured for the charge mobility and the X-ray reflection peak height. The results are shown in Table 1.

### <<Example 13 (Comparison)>>

The F8T2 solution used in Example 9 was spin-coated (1,800 rpm, 20 seconds) directly on the silicon substrate used in Example 1. That is, a semiconductor film was formed directly on the substrate without using a stamp.

A source electrode and a drain electrode were formed on the obtained organic semiconductor film in the same manner as in Example 1 to obtain a thin-film transistor.

The thus-obtained thin-film transistor, i.e., a thin-film transistor in which the active surface of the organic semiconductor layer was not subjected to a maturing step in the state of facing air, was measured for the charge mobility. However, in the organic semiconductor layer obtained in this Example, meaningful semiconductor characteristics were not observed. The result is shown in Table 1.

**[Table 1]**

| Table 1 | | | | | | | |
|---|---|---|---|---|---|---|---|
| | Material | Maturing | Water Contact Angle of First Stamp (transfer part/ peripheral part) | Mobility (cm²/Vs) | | | Relative X-ray Peak Height |
| | | | | | | Ratio of Air-Side Surface/Stamp-Side Surface | |
| Example 1 | P3HT | done | 110°/44° | 1.6×10⁻⁰² | air-side surface | 2.8 | 2.5 |
| | | | | 5.7×10⁻⁰³ | stamp-side surface | | |
| Example 2 | P3HT | done | 107°/40° | 1.4×10⁻⁰² | air-side surface | 4.5 | 2.4 |
| | | | | 3.1×10⁰³ | stamp-side surface | | |
| Example 2A | P3HT | done | 105°/39° | 1.4×10⁻⁰² | air-side surface | 7 | 2.3 |
| | | | | 2.0×10⁻⁰³ | stamp-side surface | | |
| Example 3 | P3HT | done | 104°/37° | 1.3×10⁻⁰² | air-side surface | 25 | 2.3 |
| | | | | 5.3×10⁻⁰⁴ | stamp-side surface | | |
| Example 4 | P3HT | done | 99°/33° | 1.4×10⁻⁰² | air-side surface | 51 | 2.2 |
| | | | | 2.8×10⁻⁰⁴ | stamp-side surface | | |
| Example 5 | P3HT | done | 95°/21° | 1.9×10⁻⁰² | air-side surface | 86 | 1.9 |
| | | | | 2.2×10⁻⁰⁴ | stamp-side surface | | |
| Example 6 | P3HT | done | 72°/4° | 1.5×10⁻⁰² | air-side surface | 136 | 1.8 |
| | | | | 1.1×10⁻⁰⁴ | stamp-side surface | | |
| Example 7 | P3HT | done | 44°/4° | 1.0×10⁻⁰² | air-side surface | - | 1.0 |
| | | | | (impossible of transfer) | stamp-side surface | | |
| Example 8 | P3HT | done | 8°/4° | 5.0×10⁻⁰³ | air-side surface | - | 0.03 |
| | | | | (impossible of transfer) | stamp-side surface | | |
| Example 9 | F8T2 | done | 110°/44° | 4.4×10⁻⁰⁴ | air-side surface | (∞) | - |
| | | | | (no semiconductor characteristics) | stamp-side surface | | |
| Example 10 | P3HT | none | 110°/44° | 2.7×10⁻⁰³. | air-side surface | (0.47) | - |
| (Comparison) | | (done) | | (5.7×10⁻⁰³) | stamp-side surface | | |
| Example 11 (Comparison) | P3HT | - | 110°/110° | (impossible of film formation) | | - | - |
| Example 12 (Comparison) | P3HT | ( without stamp) | | 1.8×10⁻⁰⁴ | | - | 1 (base) |
| Example 13 (Comparison) | F8T2 | ( without stamp) | | (no semiconductor characteristics) | | - | - |

As understood from Examples 1 to 10 in Table 1, in the stamp having a transfer part-peripheral part structure, an organic semiconductor film could be stably formed even on a hydrophobic surface. In particular, as understood from Examples 1 to 3 in Table 1, in the stamp having a transfer part-peripheral part structure, an organic semiconductor film could be stably formed even on a hydrophobic surface where the water contact angle exceeds 100°. On the other hand, as understood from Example 11 (Comparison) in Table 1, in the stamp not having a transfer part-peripheral part structure, it was difficult to stably form an organic semiconductor film on a hydrophobic surface.

In the organic semiconductor films of Examples 1 to 9 obtained by performing maturing, the value of the ratio of charge mobilities on two opposing surfaces {(charge mobility on the surface with high charge mobility)/(charge mobility on the surface with low charge mobility)} was large as compared with Example 10 (Comparison) where maturing was not performed. Also, as the hydrophobicity in the transfer part of the stamp used for film production was lowered, i.e., as the transfer part of the stamp used for film production became hydrophilic, the value of the ratio above becomes larger.

In the organic semiconductor films of Examples 1 to 2A, the value of the ratio of charge mobilities on two opposing surfaces {(charge mobility on the surface with high charge mobility)/(charge mobility on the surface with low charge mobility)} was large as compared with Examples 3 to 6 and at the same time, the relative X-ray peak height indicative of the degree of crystallization over the entire thickness of the organic semiconductor film was large. This is considered to be a result because crystallization of the organic semiconductor material proceeded on both the surface contacting the surface of the substrate or first stamp and the opposite surface at the film production.

As the water contact angle of the transfer part became smaller (or the surface of the transfer part becomes hydrophilic), i.e., as the surface energy of the transfer part was lowered, the relative X-ray peak height indicative of the degree of crystallization over the entire thickness of the organic semiconductor film became smaller. This is considered to be a result because as understood from the fact that the charge mobility was relatively low on the surface contacting the surface of the substrate or first stamp 15 at the film production, when the water contact angle of the transfer part was small (or when the surface of the transfer part was hydrophilic), i.e., when the surface energy was large, the degree of crystallization of the organic semiconductor material was low on this surface.

As understood from Table 1, in the organic semiconductor film of Example 10 (Comparison) where maturing was not performed, the value of the ratio of charge mobilities on two opposing surfaces was small, but the relative X-ray peak height indicative of the degree of crystallization over the entire thickness of the organic semiconductor film was also small. Incidentally, with respect to the organic semiconductor film of Example 10 (Comparison), the value of the organic semiconductor film of Example 1 was temporarily used as the value of the charge mobility of the surface located on the stamp side at the film production, and this is based on the understanding that the surface located on the stamp side at the film production is relatively kept from change in the charge mobility due to presence or absence of maturing.

### «Examples 14 and 15»

In Examples 14 and 15, a bottom-gate top-contact (BGTC-type) transistor was fabricated.

### «Example 14»

A thin-film transistor in which the surface located on the air side at the film production serves as the active surface was manufactured through one transfer in the same manner as in Example 1, except that the silicon substrate was treated with hexamethyldisilazane (HMDS) and in the transfer step, the substrate temperature was set to 130°C so as to facilitate the transfer. The obtained thin-film transistor was measured for the charge mobility. The result is shown in Table 2. The water contact angle on the surface of the silicon substrate treated with hexamethyldisilazane (HMDS) was 75°.

Incidentally, the treatment of the substrate with hexamethyldisilazane (HMDS) was performed as follows.

A 20 mM toluene solution of HMDS was prepared, and the silicon substrate above was dipped in the obtained HMDS solution and kept for 7 days. After dipping, the substrate was washed with toluene and ethanol and ultrasonically washed in ethanol for over 30 minutes. All of the steps up to here were performed in a glove box where the humidity was controlled to 3% or less. Thereafter, the substrate was washed with pure water and then heat-treated at 100°C for 5 minutes to obtain an HMDS-treated substrate.

### «Example 15»

A thin-film transistor in which the surface located on the air side at the film production serves as the active surface was manufactured through one transfer in the same manner as in Example 1 except that the silicon substrate was treated with octadecyltrichlorosilane (OTS) and in the transfer step, the substrate temperature was set to 130°C so as to facilitate the transfer. The obtained thin-film transistor was measured for the charge mobility. The result is shown in Table 2. The water contact angle on the surface of the silicon substrate treated with octadecyltrichlorosilane (OTS) was 108°.

Incidentally, the treatment of the substrate with octadecyltrichlorosilane was performed as follows.

A 20 mM toluene solution of OTS was prepared, and the silicon substrate above was dipped in the obtained OTS solution and kept for 7 days. After dipping, the substrate was washed with toluene and ethanol and ultrasonically washed in ethanol over 30 minutes. All of the steps up to here were performed in a glove box where the humidity was controlled to 3% or less. Thereafter, the substrate was washed with pure water and then heat-treated at 100°C for 5 minutes to obtain an OTS-treated substrate.

**[Table 2]**

| Table 2 | | | |
|---|---|---|---|
| | Water Contact Angle of Undercoat Layer (substrate) | Mobility (cm²/Vs) | |
| Example 1 | 4° (SiO₂/Si) | 1.6×10⁻⁰² | (air-side surface) |
| Example 14 | 75° (HMDS) | 3.0×10⁻⁰² | (air-side surface) |
| Example 15 | 108° (OTS) | 2.8×0⁻⁰² | (air-side surface) |

In Table 2, the results of the organic semiconductor film of Example 1 are shown together for the purpose of comparison. As understood from Table 2, even when an organic semiconductor film is matured on the stamp, and then transferred onto a substrate, the surface energy of the substrate affects the charge mobility of the organic semiconductor film. That is, it is understood from Table 2 that even in the case of maturing an organic semiconductor film on a stamp, and then transferring the film onto a substrate, the surface energy of the substrate is preferably small so as to obtain an organic semiconductor film with high charge mobility.

### «Examples 16 to 27»

In Examples 16 to 21, a bottom-gate top-contact (BGTC-type) transistor was fabricated, and in Examples 22 to 27, a bottom-gate bottom-contact (BGBC-type) transistor was fabricated.

### «Example 16»

A bottom-gate top-contact (BGTC-type) thin-film transistor was fabricated in the same manner as in Example 1 (ratio of air-side surface/stamp-side surface: 2.8, relative X-ray peak intensity: 2.5), except that a P3HT solution as the organic semiconductor solution was obtained by dissolving 0.5 parts by mass of P3HT in 99.5 parts by mass of toluene.

The thus-obtained thin-film transistor, i.e., a thin-film transistor in which the surface located on the air side at the film production serves as the active surface, was measured for the charge mobility. The result is shown in Table 3.

### «Example 17»

A BGTC-type thin-film transistor in which the surface located on the air side at the film production serves as the active surface, was manufactured in the same manner as in Example 16 except that the silicon substrate was treated with hexamethyldisilazane (HMDS) in the same manner as in Example 14 and in the transfer step, the substrate temperature was set to 130°C so as to facilitate the transfer. The obtained thin-film transistor was measured for the charge mobility. The result is shown in Table 3.

### «Example 18»

A BGTC-type thin-film transistor in which the surface located on the air side at the film production serves as the active surface, was manufactured in the same manner as in Example 16 except that the silicon substrate was treated with octadecyltrichlorosilane (OTS) in the same manner as in Example 15 and in the transfer step, the substrate temperature was set to 130°C so as to facilitate the transfer. The obtained thin-film transistor was measured for the charge mobility. The result is shown in Table 3.

### <<Example 19 (Comparison)>>

A BGTC-type thin-film transistor was obtained by spin-coating (1,800 rpm, 20 seconds) the P3HT solution used in Example 16 directly on the silicon substrate used in Example 16. The charge mobility of the obtained thin-film transistor is shown in Table 3.

### «Example 20 (Comparison)>>

A BGTC-type thin-film transistor was obtained by spin-coating (1,800 rpm, 20 seconds) the P3HT solution used in Example 16 directly on the HMDS-treated silicon substrate used in Example 17. The charge mobility of the obtained thin-film transistor is shown in Table 3.

### «Example 21 (Comparison)>>

A BGTC-type thin-film transistor was obtained by spin-coating (1,800 rpm, 20 seconds) the P3HT solution used in Example 16 directly on the OTS-treated silicon substrate used in Example 18. The charge mobility of the obtained thin-film transistor is shown in Table 3.

### «Example 22»

A thin-film transistor was fabricated in the same manner as in Example 1 (ratio of air-side surface/stamp-side surface: 2.8, relative X-ray peak intensity: 2.5) except that a P3HT solution as the organic semiconductor solution was obtained by dissolving 0.5 parts by mass of P3HT in 99.5 parts by mass of toluene and gold was vacuum-deposited on a silicon wafer substrate after UV-ozone cleaning by a mask vapor deposition method to form a source electrode and a drain electrode (L/w=50 µm/1.5 mm), thereby fabricating a bottom-gate bottom-contact (BGBC-type) thin-film transistor. That is, a thin-film transistor was fabricated in the same manner as in Example 6, except for manufacturing a BGBC-type thin-film transistor by using a silicon wafer substrate having a gold electrode.

The thus-obtained thin-film transistor, i.e., a thin-film transistor in which the surface located on the air side at the film production serves as the active surface, was measured for the charge mobility. The result is shown in Table 3.

### «Example 23»

A BGBC-type thin-film transistor in which the surface located on the air side at the film production serves as the active surface, was manufactured in the same manner as in Example 22 except that the silicon substrate was treated with hexamethyldisilazane (HMDS) in the same manner as in Example 14 and in the transfer step, the substrate temperature was set to 130°C so as to facilitate the transfer. The obtained thin-film transistor was measured for the charge mobility. The result is shown in Table 3.

### «Example 24»

A BGBC-type thin-film transistor in which the surface located on the air side at the film production serves as the active surface, was manufactured in the same manner as in Example 22, except that the silicon substrate was treated with octadecyltrichlorosilane (OTS) in the same manner as in Example 15 and in the transfer step, the substrate temperature was set to 130°C so as to facilitate the transfer. The obtained thin-film transistor was measured for the charge mobility. The result is shown in Table 3.

### «Example 25»

A thin-film transistor was fabricated in the same manner as in Example 22, except that the contact printing stamp was produced by the method of Example 5 (ratio of air-side surface/stamp-side surface: 8.6, relative X-ray peak intensity: 1.9). The charge mobility of the obtained thin-film transistor is shown in Table 3.

### «Example 26»

A thin-film transistor was fabricated in the same manner as in Example 23, except that the contact printing stamp was produced by the method of Example 5. The charge mobility of the obtained thin-film transistor is shown in Table 3.

### «Example 27»

A thin-film transistor was fabricated in the same manner as in Example 24, except that the contact printing stamp was produced by the method of Example 5. The charge mobility of the obtained thin-film transistor is shown in Table 3.

### «Example 28 (Comparison)>>

A BGBC-type thin-film transistor was obtained by spin-coating (1,800 rpm, 20 seconds) the P3HT solution used in Example 22 directly on the silicon substrate used in Example 22. The charge mobility of the obtained thin-film transistor is shown in Table 3.

### «Example 28 (Comparison)>>

A BGBC-type thin-film transistor was obtained by spin-coating (1,800 rpm, 20 seconds) the P3HT solution used in Example 22 directly on the HMDS-treated silicon substrate used in Example 23. The charge mobility of the obtained thin-film transistor is shown in Table 3.

### «Example 30 (Comparison)>>

A BGBC-type thin-film transistor was obtained by spin-coating (1,800 rpm, 20 seconds) the P3HT solution used in Example 22 directly on the OTS-treated silicon substrate used in Example 24. The charge mobility of the obtained thin-film transistor is shown in Table 3.

**[Table 3]**

| Table 3 | | | | | | | |
|---|---|---|---|---|---|---|---|
| | Structure | Manufacturing Method | Substrate Treatment | | Mobility (cm²/Vs) | | Relative X-Ray Peak Height |
| | | | | | Ratio to Spin Coating Method | | |
| Example 16 | BGTC type | contact printing method | none | 2.2×10⁻² | 79 | (Example 16)/(Example 19) | 2.5 |
| Example 17 | | contact printing method | HMDS | 3.5×10⁻² | 125 | (Example 17)/(Example 20) | - |
| Example 18 | | contact printing method | OTS | 6.1×10⁻² | 2 | (Example 18)/(Example 21) | 4 |
| Example 19 | | spin coating method | none | 2.8×10⁻⁴ | - | - | 1 (base) |
| Example 20 | | spin coating method | HMDS | 2.8×10⁻⁴ | - | - | - |
| Example 21 | | spin coating method | OTS | 2.6×10⁻² | - | - | 1.7 |
| Example 22 | | contact printing method | none | 5.4×10³ | 270 | (Example 22)/(Example 28) | 2.5 |
| Example 23 | | contact printing method | HMDS | 1.1×10⁻² | 196 | (Example 23)/(Example 29) | - |
| Example 24 | | contact printing method | OTS | 3.6×10⁻² | 7 | (Example 24)/(Example 30) | 4 |
| Example 25 | BGBC type | contact printing method | none | 5.5×10⁻³ | 275 | (Example 25)/(Example 28) | 1.9 |
| Example 26 | | contact printing method | HMDS | 1.0×10⁻² | 179 | (Example 26)/(example 29) | - |
| Example 27 | | contact printing method | OTS | 3.5×10⁻² | 7 | (Example 27)/(Example 30) | - |
| Example 28 | | spin coating method | none | 2.0×10⁻⁵ | - | - | 1 (base) |
| Example 29 | | spin coating method | HMDS | 5.6×10⁻⁵ | - | - | - |
| Example 30 | | spin coating method | OTS | 5.2×10⁻³ | - | - | 1.7 |

As understood from Table 3, the thin-film transistors of Examples 16 to 18 and Examples 22 to 27 manufactured by the contact printing method have good charge mobility as compared with the corresponding thin-film transistors of Examples 19 to 21 and Examples 28 to 30 manufactured by the spin coating method.

In Table 3, the "Ratio to Spin Coating" indicates the ratio between the charge mobility of the thin-film transistor manufactured by the contact printing method and the mobility of the corresponding thin-film transistor manufactured by the spin coating method. As understood from this ratio, the rate of increase in the mobility due to using the contact printing method at the fabrication of a bottom-gate bottom-contact (BGBC-type) thin-film transistor is larger than in the case of using the contact printing method at the fabrication of a bottom-gate top-contact (BGTC-type) thin-film transistor. More specifically, it is understood that in the fabrication of a BGBC-type thin-film transistor, use of the contact printing method is preferred.

### DESCRIPTION OF NUMERICAL REFERENCES

10, 133, 143, 153, 163: Organic semiconductor film of the present invention
11: Organic semiconductor film of the present invention (surface contacting substrate)
12: Organic semiconductor film of the present invention (surface opposite the surface contacting substrate)
15, 100: Substrate
20: Conventional organic semiconductor film
21: Conventional organic semiconductor film (surface contacting substrate)
22: Conventional organic semiconductor film (surface opposite the surface contacting substrate)
130, 140, 150, 160: Thin-film transistor of the present invention
131, 141, 151, 161: Gate electrode
132, 142, 152, 162: Gate insulating film
133, 143, 153, 163: Semiconductor film
134, 144, 154, 164: Source electrode
135, 145, 155, 165: Drain electrode
50: Stamp having a transfer part-peripheral part structure
51, 51a, 51b, 51c: Transfer part
52, 52a, 52b, 52c: Peripheral part
61: Organic semiconductor solution

## Claims

1. An organic semiconductor film, wherein the value of the ratio of charge mobilities on two opposing surfaces {(charge mobility on the surface with high charge mobility)/(charge mobility on the surface with low charge mobility)} is from 1 to less than 10; and the relative X-ray reflection peak height is 2.0 or more on the basis of the peak height for an organic semiconductor film having the same thickness, made of the same material and produced by spin coating on a silicon wafer.

2. The organic semiconductor film according to claim 1, wherein the value of the ratio of charge mobilities is 5 or less.

3. The organic semiconductor film according to claim 1 or 2, wherein the organic semiconductor film is obtained by a solution method.

4. The organic semiconductor film according to any one of claims 1 to 3, wherein the organic semiconductor film is obtained by a contact printing method.

5. The organic semiconductor film according to any one of claims 1 to 4, wherein the charge mobility on the surface with high charge mobility of the organic semiconductor film is 1.00×10⁻⁵ cm²/(V·s) or more.

6. A method for producing an organic semiconductor film, comprising:
providing an organic semiconductor solution comprising an organic semiconductor material dissolved and/or dispersed therein,
applying the organic semiconductor solution on a substrate or a first stamp to obtain an undried organic semiconductor film, and
maturing the undried organic semiconductor film on the substrate or first stamp,
wherein the water contact angle on the surface of the substrate or first stamp is 100° or more.

7. The method according to claim 6, wherein the maturing is performed by holding the undried organic semiconductor film over 10 seconds or more.

8. The method according to claim 6 or 7, wherein the maturing is performed by holding the undried organic semiconductor film in an atmosphere having a temperature of less than 50°C.

9. The method according to any one of claims 6 to 8, further comprising transferring the organic semiconductor layer matured on the first stamp.

10. The method according to any one of claims 6 to 9, further comprising drying and/or thermal annealing the organic semiconductor layer matured on the substrate or first stamp.

11. The method according to any one of claims 6 to 10, wherein the water contact angle on the surface of the substrate or first stamp is 105° or more.

12. An organic semiconductor device having the organic semiconductor film of any one of claims 1 to 5.

13. The organic semiconductor device according to claim 12, which is a thin-film transistor.

14. The organic semiconductor device according to claim 13, wherein the organic semiconductor film is obtained by a contact printing method, and the organic semiconductor device is a bottom-gate bottom-contact or top-gate bottom-contact thin-film transistor.

15. An organic semiconductor film, wherein the value of the ratio of charge mobilities on two opposing surfaces {(charge mobility on the surface with high charge mobility)/(charge mobility on the surface with low charge mobility)} is 2 or more.

16. The organic semiconductor film according to claim 15, wherein the value of the ratio of charge mobilities is 10 or more.

17. The organic semiconductor film according to claim 15 or 16, wherein the value of the ratio of charge mobilities is 150 or less.

18. The organic semiconductor film according to any one of claims 15 to 17, wherein the organic semiconductor film is obtained by a solution method.

19. The organic semiconductor film according to any one of claims 15 to 18, wherein the organic semiconductor film is obtained by a contact printing method.

20. The organic semiconductor film according to any one of claims 15 to 19, wherein the charge mobility on the surface with high charge mobility of the organic semiconductor film is 1.00×10⁻⁵ cm²/(V·s) or more.

21. The organic semiconductor film according to any one of claims 15 to 20, wherein the relative X-ray reflection peak height is 1.3 or more on the basis of the peak height for an organic semiconductor film having the same thickness, made of the same material and produced by spin coating on a silicon wafer.

22. The organic semiconductor film according to any one of claims 15 to 21, wherein the degree of crystal orientation of an organic semiconductor material constituting the organic semiconductor film is gradually changed between the two opposing surfaces.

23. A method for producing an organic semiconductor film, comprising:
providing an organic semiconductor solution comprising an organic semiconductor material dissolved and/or dispersed therein,
applying the organic semiconductor solution on a substrate or a first stamp to obtain an undried organic semiconductor film, and
maturing the undried organic semiconductor film on the substrate or first stamp.

24. The method according to claim 23, wherein the maturing is performed by holding the undried organic semiconductor film over 10 seconds or more.

25. The method according to claim 23 or 24, wherein the maturing is performed by holding the undried organic semiconductor film in an atmosphere having a temperature of less than 50°C.

26. The method according to any one of claims 23 to 25, further comprising transferring the organic semiconductor layer matured on the first stamp.

27. The method according to any one of claims 23 to 26, further comprising drying and/or thermal annealing the organic semiconductor layer matured on the substrate or first stamp.

28. The method according to any one of claims 23 to 27, wherein the water contact angle on the surface of the substrate or first stamp is 40° or more.

29. An organic semiconductor device having the organic semiconductor film of any one of claims 15 to 22.

30. The organic semiconductor device according to claim 29, which is a thin-film transistor.

31. The organic semiconductor device according to claim 30, wherein the organic semiconductor film is obtained by a contact printing method, and the organic semiconductor device is a bottom-gate bottom-contact or top-gate bottom-contact thin-film transistor.

32. An electric circuit comprising a circuit substrate having on one surface thereof two or more thin-film transistors of claim 30 or 31,
wherein, in at least one of the thin-film transistors, the organic semiconductor film is disposed by arranging the surface with high charge mobility of the organic semiconductor film to face the circuit substrate, and this surface serves as the active surface of the thin-film transistor, and
wherein, in at least another one of the thin-film transistors, the organic semiconductor film is disposed by arranging the surface with high charge mobility of the organic semiconductor film to face opposite the circuit substrate, and this surface serves as the active surface of the thin-film transistor.

33. A contact printing stamp having a transfer part for holding an organic semiconductor film to be transferred, and a peripheral part surrounding the transfer part, wherein the water contact angle of the transfer part is larger by 20° or more than the water contact angle of the peripheral part.

34. The stamp according to claim 33, wherein the water contact angle of the transfer part is 40° or more.

35. The stamp according to claim 33 or 34, wherein the transfer part and the peripheral part are on the same plane.

36. The stamp according to any one of claims 33 to 35, wherein the transfer part is concaved with respect to the peripheral part.

37. The stamp according to any one of claims 33 to 36, wherein the size of the transfer part is from 0.01 to 1,000,000 µm².

38. A method for producing an organic semiconductor film, comprising:
providing an organic semiconductor solution containing a solvent and an organic semiconductor material dissolved and/or dispersed in the solvent, and
applying the organic semiconductor solution on the transfer part of the stamp of any one of claims 33 to 37 to obtain an organic semiconductor film.
